(19) Europäisches Patentamt
European Patent Office
Office européen des brevets

(11) EP 3 137 929 B1

(12) FASCICULE DE BREVET EUROPEEN

(45) Date de publication et mention de la délivrance du brevet:
**23.10.2019 Bulletin 2019/43**

(21) Numéro de dépôt: **14725749.7**

(22) Date de dépôt: **28.04.2014**

(51) Int Cl.:
***G02B 1/11*** *(2015.01)*

(86) Numéro de dépôt international:
**PCT/FR2014/051016**

(87) Numéro de publication internationale:
**WO 2015/166144 (05.11.2015 Gazette 2015/44)**

# (54) ARTICLE À PROPRIÉTÉS THERMOMÉCANIQUES OPTIMISÉES COMPORTANT UNE COUCHE DE NATURE TITANO-ORGANIQUE

ARTIKEL MIT OPTIMIERTEN THERMOMECHANISCHEN EIGENSCHAFTEN MIT EINER TITANORGANISCHEN SCHICHT

ARTICLE WITH OPTIMISED THERMOMECHANICAL PROPERTIES HAVING A TITANO-ORGANIC LAYER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**08.03.2017 Bulletin 2017/10**

(73) Titulaires:
- **Corporation de L'Ecole Polytechnique de Montreal**
  **Montréal, Québec H3T 1J4 (CA)**
- **Essilor International**
  **94220 Charenton-le-Pont (FR)**

(72) Inventeurs:
- **ZABEIDA, Oleg**
  **Cote Saint-luc, Québec H4V 2G9 (CA)**
- **SCHMITT, Thomas**
  **Montreal, Québec H2H 1W2 (CA)**
- **SAPIEHA, Jolanta**
  **Pointe Claire, Québec H9R 3P8 (CA)**
- **MARTINU, Ludvik**
  **Montreal, Québec H3W 2B4 (CA)**
- **SCHERER, Karin**
  **F-94220 Charenton Le Pont (FR)**

(74) Mandataire: **Jacobacci Coralis Harle**
**32, rue de l'Arcade**
**75008 Paris (FR)**

(56) Documents cités:
**EP-A1- 1 176 434**
**EP-A1- 2 711 744**
**WO-A1-2007/064108**
**DE-B3-102012 112 780**
**US-A1- 2004 124 531**

- **Matthias Schiller ET AL: "PICVD -A novel technique for hard-and AR-coating of spectacles", SPIE proceedings 3738, Advances in Optical Interference Coatings,, 7 septembre 1999 (1999-09-07), XP055162294, DOI: 10.1117/12.360084 Extrait de l'Internet: URL:http://proceedings.spiedigitallibrary. org/proceeding.aspx?articleid=991774 [extrait le 2015-01-15]**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 137 929 B1

## Description

La présente invention concerne d'une manière générale un article, de préférence un article d'optique, notamment une lentille ophtalmique, possédant une couche de nature titano-organique, alliant propriétés thermomécaniques et indice de réfraction élevé, ainsi qu'un procédé de préparation d'un tel article.

Il est connu de traiter les verres ophtalmiques, qu'ils soient minéraux ou organiques, de façon à empêcher la formation de reflets parasites gênants pour le porteur de la lentille et ses interlocuteurs. La lentille est alors pourvue d'un revêtement antireflet mono- ou multicouche, généralement en matière minérale, lequel présente dans le second cas une alternance de couches de haut indice de réfraction et de bas indice de réfraction.

Un revêtement réfléchissant réalise l'effet inverse, c'est-à-dire qu'il augmente la réflexion des rayons lumineux. Un tel type de revêtement est utilisé par exemple, pour obtenir un effet miroir dans des lentilles solaires.

Lors du taillage et du montage d'un verre chez l'opticien, le verre subit des déformations mécaniques qui peuvent provoquer des fissures dans les revêtements interférentiels réfléchissants ou antireflet minéraux, en particulier lorsque l'opération n'est pas conduite avec soin. De façon similaire, des sollicitations en température (chauffage de la monture) peuvent provoquer des fissures dans le revêtement interférentiel. Selon le nombre et la taille des fissures, celles-ci peuvent gêner la vue pour le porteur et empêcher la commercialisation du verre. En outre, pendant le port de verres organiques traités, des rayures peuvent apparaître. Dans les revêtements interférentiels minéraux, certaines rayures entraînent des fissurations, rendant les rayures plus visibles à cause d'une diffusion de lumière.

Un objectif de l'invention est l'obtention d'un revêtement, notamment un revêtement interférentiel, et en particulier antireflet, ayant des propriétés thermomécaniques améliorées, tout en conservant un indice de réfraction élevé, avec de préférence de bonnes propriétés d'adhérence. L'invention vise en particulier des articles possédant une température critique améliorée, c'est à dire, présentant une bonne résistance à la craquelure lorsqu'ils sont soumis à une élévation de température. Un autre objectif de l'invention est de disposer d'un procédé de fabrication d'un revêtement interférentiel simple, facile à mettre en oeuvre et reproductible.

Il est également connu de déposer des couches minces organique / inorganique par voie liquide. Cette technique de dépôt présente des inconvénients tels que la difficulté d'étalement et de polymérisation des couches sans créer des craquelures sur des substrats organiques, la durée du procédé, en particulier lorsque d'autres revêtements doivent être déposés sur ces couches.

La demande WO 2013/098531, au nom du demandeur, décrit un article ayant des performances thermomécaniques améliorées, comprenant un substrat ayant au moins une surface principale revêtue d'un revêtement interférentiel multicouche, ledit revêtement comprenant une couche A non formée à partir de composés précurseurs inorganiques ayant un indice de réfraction inférieur ou égal à 1,55, qui constitue :

- ◦ soit la couche externe du revêtement interférentiel,
- ◦ soit une couche intermédiaire, directement en contact avec la couche externe du revêtement interférentiel, cette couche externe du revêtement interférentiel étant dans ce second cas une couche additionnelle ayant un indice de réfraction inférieur ou égal à 1,55, et ladite couche A ayant été obtenue par dépôt, sous faisceau d'ions, d'espèces activées issues d'au moins un composé précurseur C sous forme gazeuse de nature silico-organique tel que l'octaméthylcyclotétrasiloxane (OMCTS).

La demande EP 1324078 décrit une lentille revêtue d'un revêtement antireflet multicouche comprenant une alternance de couches de haut et de bas indice de réfraction dont la couche externe est une couche de bas indice de réfraction (1,42-1,48) consistant en une couche hybride, obtenue par dépôt sous vide et sous assistance ionique simultanément d'un composé organique (par exemple le polyéthylène glycol glycidyl éther, le polyéthylène glycol monoacrylate ou le N-(3-triméthoxysilylpropyl)gluconamide) et d'au moins un composé inorganique (silice ou silice et alumine), c'est-à-dire par co-évaporation de ces différents constituants.

Le brevet US 6,919,134 décrit un article d'optique comportant un revêtement antireflet comprenant au moins une couche dite "hybride" obtenue par co-évaporation d'un composé organique et d'un composé inorganique ($SiO_2$, $SiO_2$ + $Al_2O_3$, $Nb_2O_5$, $Ta_2O_5$, $TiO_2$, $ZrO_2$ ou $Y_2O_3$), qui lui confère une meilleure adhésion, une meilleure résistance thermique et une meilleure résistance à l'abrasion. Cette couche est généralement déposée par co-évaporation sous assistance ionique typiquement de silice et d'une huile de silicone modifiée.

Les demandes JP 2007-078780 et JP 05-323103 décrivent d'autres empilements optiques multicouches comportant des couches hybrides organiques-inorganiques.

Les inventeurs ont constaté que les matériaux des couches de haut indice de réfraction des empilements interférentiels étaient plus fragiles que les matériaux de bas indice de réfraction et avaient une tenue à la température bien moindre. Ainsi, les inventeurs ont mis au point un matériau de couche de haut indice de réfraction, transparent, utilisable dans des filtres interférentiels, permettant de remplir les objectifs fixés. Ce matériau peut être utilisé pour remplacer des matériaux de haut indice de réfraction traditionnels tels que le dioxyde de titane dans les revêtements

interférentiels.

Selon l'invention, la couche de matériau de haut indice de réfraction est formée par dépôt sous assistance d'une source d'ions, préférentiellement sous un faisceau d'ions, mieux encore issu d'un canon à ions, d'espèces activées, sous forme gazeuse, obtenues à partir d'un matériau précurseur de nature organique et d'un matériau précurseur de nature inorganique. Elle possède des propriétés thermomécaniques améliorées tout en présentant un indice de réfraction et une transparence élevés.

Les buts fixés sont donc atteints selon l'invention par un article comprenant un substrat ayant au moins une surface principale revêtue d'une couche A d'un matériau obtenu par dépôt sous vide assisté par une source d'ions, cette assistance étant de préférence un bombardement ionique, d'au moins un oxyde de titane et d'au moins un composé B organosilicié, ledit matériau présentant :

- un indice de réfraction à 550 nm supérieur ou égal à 1,8,
- un coefficient d'extinction k à 550 nm inférieur ou égal à 0,02,
- un ratio H/E supérieur ou égal à 0,046, où H et E désignent respectivement la dureté du matériau et le module d'élasticité du matériau.

Le protocole de mesure de H et E est décrit dans la partie expérimentale.
Il est possible de se référer à la norme NF EN ISO 14577 en cas de besoin.
H et E sont exprimés dans la même unité (par exemple MPa ou GPa).

L'invention concerne également un procédé de fabrication d'un tel article, comprenant au moins les étapes suivantes :

- fournir un article comprenant un substrat ayant au moins une surface principale,
- déposer sur ladite surface principale du substrat une couche A d'un matériau ayant un indice de réfraction supérieur ou égal à 1,8, un coefficient d'extinction k à 550 nm inférieur ou égal à 0,02, un ratio H/E supérieur ou égal à 0,046, où H et E ont la signification indiquée ci-dessus,
- récupérer un article comprenant un substrat ayant une surface principale revêtue d'une couche A,

ladite couche A ayant été obtenue par dépôt sous vide et sous l'assistance d'une source d'ions, préférentiellement un bombardement ionique d'au moins un oxyde de titane et d'au moins un composé B organosilicié.

Dans la présente demande, lorsqu'un article comprend un ou plusieurs revêtements à sa surface, l'expression "déposer une couche ou un revêtement sur l'article" signifie qu'une couche ou un revêtement est déposé sur la surface à découvert (exposée) du revêtement externe de l'article, c'est-à-dire son revêtement le plus éloigné du substrat.

Un revêtement qui est "sur" un substrat ou qui a été déposé "sur" un substrat est défini comme un revêtement qui (i) est positionné au-dessus du substrat, (ii) n'est pas nécessairement en contact avec le substrat (bien que préférentiellement, il le soit), c'est-à-dire qu'un ou plusieurs revêtements intermédiaires peuvent être disposés entre le substrat et le revêtement en question, et (iii) ne recouvre pas nécessairement le substrat complètement (bien que préférentiellement, il le recouvre). Lorsque "une couche 1 est localisée sous une couche 2", on comprendra que la couche 2 est plus éloignée du substrat que la couche 1.

L'article préparé selon l'invention comprend un substrat, de préférence transparent, ayant des faces principales avant et arrière, l'une au moins desdites faces principales comportant au moins une couche A, pouvant être intégrée dans un revêtement interférentiel, de préférence les deux faces principales.

Par face arrière (généralement concave) du substrat, on entend la face qui, lors de l'utilisation de l'article, est la plus proche de l'oeil du porteur. Inversement, par face avant (généralement convexe) du substrat, on entend la face qui, lors de l'utilisation de l'article, est la plus éloignée de l'oeil du porteur.

Bien que l'article selon l'invention puisse être un article quelconque, tel qu'un écran, un vitrage, des lunettes de protection utilisables notamment en environnement de travail, un miroir, ou un article utilisé en électronique, il constitue de préférence un article d'optique, mieux une lentille optique, et encore mieux une lentille ophtalmique, pour lunettes, ou une ébauche de lentille optique ou ophtalmique telle qu'une lentille optique semi-finie, en particulier un verre de lunettes. La lentille peut être une lentille polarisée, colorée, une lentille photochrome ou électrochromique. Préférentiellement, la lentille ophtalmique selon l'invention présente une transmission élevée.

La couche A selon l'invention peut être formée sur au moins l'une des faces principales d'un substrat nu, c'est-à-dire non revêtu, ou sur au moins l'une des faces principales d'un substrat déjà revêtu d'un ou plusieurs revêtements fonctionnels.

Le substrat de l'article selon l'invention est de préférence un verre organique, par exemple en matière plastique thermoplastique ou thermodurcissable. Ce substrat peut être choisi parmi les substrats cités dans la demande WO 2008/062142, par exemple un substrat obtenu par (co)polymérisation du bis allyl carbonate du diéthylèneglycol, un substrat en poly(thio)uréthane ou un substrat en polycarbonate de bis(phénol A) (thermoplastique), noté PC, ou un

substrat en PMMA (polyméthacrylate de méthyle).

Avant le dépôt de la couche A sur le substrat éventuellement revêtu, par exemple d'un revêtement anti-abrasion et/ou anti-rayures, il est courant de soumettre la surface dudit substrat, éventuellement revêtue, à un traitement d'activation physique ou chimique, destiné à augmenter l'adhésion de la couche A. Ce prétraitement est généralement conduit sous vide. Il peut s'agir d'un bombardement avec des espèces énergétiques et/ou réactives, par exemple un faisceau d'ions ("Ion Pre-Cleaning" ou "IPC") ou un faisceau d'électrons, d'un traitement par décharge corona, par effluvage, d'un traitement UV, ou d'un traitement par plasma sous vide, généralement un plasma d'oxygène ou d'argon. Il peut également s'agir d'un traitement de surface acide ou basique et/ou par solvants (eau ou solvant organique). Plusieurs de ces traitements peuvent être combinés. Grâce à ces traitements de nettoyage, la propreté et la réactivité de la surface du substrat sont optimisées.

Par espèces énergétiques (et/ou réactives), on entend notamment des espèces ioniques ayant une énergie allant de préférence de 1 à 300 eV, préférentiellement de 1 à 150 eV, mieux de 10 à 150 eV, et mieux encore de 40 à 150 eV. Les espèces énergétiques peuvent être des espèces chimiques telles que des ions, des radicaux, ou des espèces telles que des photons ou des électrons.

Le prétraitement préféré de la surface du substrat est un traitement par bombardement ionique, effectué au moyen d'un canon à ions, les ions étant des particules constituées d'atomes de gaz dont on a extrait un ou plusieurs électron(s). On utilise de préférence en tant que gaz ionisé l'argon (ions $Ar^+$), mais également l'oxygène, ou leurs mélanges, sous une tension d'accélération allant généralement de 50 à 200 V, une densité de courant généralement comprise entre 10 et 100 $\mu A/cm^2$ sur la surface activée, et généralement sous une pression résiduelle dans l'enceinte à vide pouvant varier de $8.10^{-5}$ mbar à $2.10^{-4}$ mbar.

L'article selon l'invention comporte une couche A, qui constitue de préférence une couche haut indice d'un revêtement interférentiel multicouche, préférentiellement un revêtement interférentiel multicouche, notamment antireflet. De préférence, la couche externe d'un tel revêtement (interférentiel) multicouche, c'est-à-dire la couche du revêtement (interférentiel) la plus éloignée du substrat dans l'ordre d'empilement, n'est pas une couche A selon l'invention. Dans un mode de réalisation préféré, la couche A constitue l'avant dernière couche du revêtement (interférentiel) multicouche dans l'ordre d'empilement et se trouve directement en contact avec une couche externe de bas indice de réfraction.

La couche A ou ledit revêtement (interférentiel) multicouche est formé de préférence sur un revêtement anti-abrasion. Les revêtements anti-abrasion préférés sont des revêtements à base d'hydrolysats d'époxysilane comportant au moins deux groupements hydrolysables, de préférence au moins trois, liés à l'atome de silicium. Les groupements hydrolysables préférés sont des groupements alcoxysilane.

Le revêtement interférentiel peut être tout revêtement interférentiel classiquement utilisé dans le domaine de l'optique, en particulier de l'optique ophtalmique, excepté le fait qu'il comporte une couche A selon l'invention. Le revêtement interférentiel peut être, sans limitation, un revêtement antireflet, un revêtement réfléchissant (miroir), de préférence un revêtement antireflet.

Un revêtement antireflet se définit comme un revêtement, déposé à la surface d'un article, qui améliore les propriétés anti-réfléchissantes de l'article final. Il permet de réduire la réflexion de la lumière à l'interface article-air sur une portion relativement large du spectre visible.

Comme cela est bien connu, les revêtements interférentiels, de préférence les revêtements antireflet, comprennent classiquement un empilement monocouche ou multicouche de matériaux diélectriques. Ce sont de préférence des revêtements multicouches, comprenant des couches de haut indice de réfraction (HI) et des couches de bas indice de réfraction (BI).

Dans la présente demande, une couche du revêtement interférentiel est dite couche de haut indice de réfraction lorsque son indice de réfraction est supérieur à 1,55, de préférence supérieur ou égal à 1,6, mieux supérieur ou égal à 1,8 et encore mieux supérieur ou égal à 2,0. Une couche d'un revêtement interférentiel est dite couche de bas indice de réfraction lorsque son indice de réfraction est inférieur ou égal à 1,55, de préférence inférieur ou égal à 1,50, mieux inférieur ou égal à 1,45. Sauf indication contraire, les indices de réfraction auxquels il est fait référence dans la présente invention sont exprimés à 25°C pour une longueur d'onde de 550 nm.

Les couches HI sont des couches de haut indice de réfraction classiques, bien connues dans la technique. Elles comprennent généralement un ou plusieurs oxydes minéraux tels que, sans limitation, la zircone ($ZrO_2$), le dioxyde de titane ($TiO_2$), le pentoxyde de tantale ($Ta_2O_5$), l'oxyde de néodyme ($Nd_2O_5$), l'oxyde d'hafnium ($HfO_2$), l'oxyde de praséodyme ($Pr_2O_3$), le titanate de praséodyme ($PrTiO_3$), $La_2O_3$, $Nb_2O_5$, $Y_2O_3$, l'oxyde d'indium $In_2O_3$, ou l'oxyde d'étain $SnO_2$. Les matériaux préférés sont $TiO_2$, $Ta_2O_5$, $PrTiO_3$, $ZrO_2$, $SnO_2$, $In_2O_3$ et leurs mélanges.

Les couches BI sont également bien connues et peuvent comprendre, sans limitation, $SiO_2$, $MgF_2$, $ZrF_4$, de l'alumine ($Al_2O_3$) en faible proportion, $AlF_3$, et leurs mélanges, de préférence $SiO_2$. On peut également utiliser des couches SiOF ($SiO_2$ dopée au fluor). Idéalement, le revêtement interférentiel de l'invention ne comprend aucune couche comprenant un mélange de silice et d'alumine.

Généralement, les couches HI ont une épaisseur physique variant de 10 à 120 nm, et les couches BI ont une épaisseur physique variant de 10 à 120 nm, préférentiellement 10 à 110 nm.

Préférentiellement, l'épaisseur totale du revêtement interférentiel est inférieure à 1 micromètre, mieux inférieure ou égale à 800 nm et mieux encore inférieure ou égale à 500 nm. L'épaisseur totale du revêtement interférentiel est généralement supérieure à 100 nm, de préférence supérieure à 150 nm.

De préférence encore, le revêtement interférentiel, qui est de préférence un revêtement antireflet, comprend au moins deux couches de bas indice de réfraction (BI) et au moins deux couches de haut indice de réfraction (HI). Préférentiellement, le nombre total de couches du revêtement interférentiel est inférieur ou égal à 8, mieux inférieur ou égal à 6.

Il n'est pas nécessaire que les couches HI et BI soient alternées dans le revêtement interférentiel, bien qu'elles puissent l'être selon un mode de réalisation de l'invention. Deux couches HI (ou plus) peuvent être déposées l'une sur l'autre, tout comme deux couches BI (ou plus) peuvent être déposées l'une sur l'autre.

Selon l'invention, les couches A constituent généralement des couches de haut indice de réfraction. Le revêtement interférentiel selon l'invention peut renfermer une ou plusieurs couches A.

Dans un premier mode de réalisation, toutes les couches haut indice de réfraction du revêtement interférentiel sont des couches A.

Dans un autre mode de réalisation de l'invention, toutes les couches de haut indice de réfraction du revêtement interférentiel selon l'invention sont de nature inorganique à l'exception d'une couche A (c'est à dire que les autres couches de haut indice de réfraction du revêtement interférentiel ne contiennent de préférence pas de composé organique).

De préférence, toutes les couches du revêtement interférentiel selon l'invention sont de nature inorganique, à l'exception de la couche A, ce qui signifie que la couche A constitue de préférence la seule couche de nature organique-inorganique du revêtement interférentiel de l'invention (les autres couches du revêtement interférentiel ne contenant de préférence pas de composé organique).

Selon un mode de réalisation de l'invention, le revêtement interférentiel comprend une sous-couche. Elle constitue dans ce cas généralement la première couche de ce revêtement interférentiel dans l'ordre de dépôt des couches, c'est-à-dire la couche du revêtement interférentiel qui est au contact du revêtement sous-jacent (qui est généralement un revêtement anti-abrasion et/ou anti-rayures) ou du substrat, lorsque le revêtement interférentiel est directement déposé sur le substrat.

Par sous-couche du revêtement interférentiel, on entend un revêtement d'épaisseur relativement importante, utilisé dans le but d'améliorer la résistance à l'abrasion et/ou aux rayures dudit revêtement et/ou de promouvoir son adhésion au substrat ou au revêtement sous-jacent. La sous-couche selon l'invention peut être choisie parmi les sous-couches décrites dans la demande WO 2010/109154. Préférentiellement, la sous-couche a une épaisseur de 100 à 200 nm. Elle est préférentiellement de nature exclusivement minérale/inorganique et est préférentiellement constituée de silice $SiO_2$.

L'article de l'invention peut être rendu antistatique grâce à l'incorporation, de préférence dans le revêtement interférentiel, d'au moins une couche électriquement conductrice. Par "antistatique", on entend la propriété de ne pas retenir et/ou développer une charge électrostatique appréciable. Un article est généralement considéré comme ayant des propriétés antistatiques acceptables lorsqu'il n'attire et ne fixe pas la poussière et les petites particules après que l'une de ses surfaces a été frottée au moyen d'un chiffon approprié.

La nature et la localisation dans l'empilement de la couche électriquement conductrice pouvant être utilisée dans l'invention sont décrites plus en détail dans la demande WO 2013/098531. Il s'agit de préférence d'une couche de 1 à 20 nm d'épaisseur comprenant de préférence au moins un oxyde métallique choisi parmi l'oxyde d'étain-indium ($In_2O_3$:Sn, oxyde d'indium dopé à l'étain noté ITO), l'oxyde d'indium ($In_2O_3$), et l'oxyde d'étain ($SnO_2$).

Les différentes couches du revêtement interférentiel (dont fait partie la couche antistatique optionnelle) autres que la ou les couches A sont préférentiellement déposées par dépôt sous vide selon l'une des techniques suivantes : i) par évaporation, éventuellement assistée par faisceau ionique ; ii) par pulvérisation par faisceau d'ion ; iii) par pulvérisation cathodique ; iv) par dépôt chimique en phase vapeur assisté par plasma. Ces différentes techniques sont décrites dans les ouvrages "Thin Film Processes" and "Thin Film Processes II," Vossen & Kern, Ed., Academic Press, 1978 et 1991 respectivement. Une technique particulièrement recommandée est la technique d'évaporation sous vide. De préférence, le dépôt de chacune des couches du revêtement interférentiel est réalisé par évaporation sous vide.

La couche A constitue généralement une couche de haut indice de réfraction au sens de l'invention, du fait de son indice de réfraction supérieur ou égal à 1,8. De préférence, selon des modes de réalisation de l'invention, l'indice de réfraction de la couche A est supérieur ou égal à 1,9, mieux supérieur ou égal à 2,0, mieux encore supérieur ou égal à 2,05 et idéalement supérieur ou égal à 2,1.

La couche A est formée d'un matériau obtenu par dépôt sous vide et sous l'assistance d'une source d'ions, préférentiellement sous bombardement ionique de deux catégories de précurseurs, notamment par co-évaporation : au moins un oxyde de titane et au moins un composé B organosilicié. Cette technique de dépôt sous faisceau d'ions permet d'obtenir des espèces activées issues d'au moins un composé B organosilicié et d'au moins un oxyde de titane, sous forme gazeuse.

De préférence, le dépôt est effectué dans une enceinte à vide, comportant un canon à ions dirigé vers les substrats à revêtir, qui émet vers ceux-ci un faisceau d'ions positifs générés dans un plasma au sein du canon à ions. Préférentiellement les ions issus du canon à ions sont des particules constituées d'atomes de gaz dont on a extrait un ou plusieurs électron(s), et formés à partir d'un gaz rare, d'oxygène ou d'un mélange de deux ou plus de ces gaz.

Des précurseurs, le composé B silico-organique et l'oxyde de titane, sont introduits ou passent dans un état gazeux dans l'enceinte à vide. Ils sont de préférence amenés en direction du faisceau d'ions et sont activés sous l'effet du canon à ions.

Sans vouloir être limités par une quelconque théorie, les inventeurs pensent que le canon à ions induit une activation/dissociation du composé précurseur B et de l'oxyde de titane précurseur, ce qui formerait des liaisons Ti-O-Si-$CH_x$.

Cette technique de dépôt utilisant un canon à ions et un précurseur gazeux, parfois désignée par « ion beam deposition » est décrite notamment, avec des seuls précurseurs organiques dans le brevet US 5508368.

Selon l'invention, de façon préférentielle, le seul endroit de l'enceinte où un plasma est généré est le canon à ions.

Les ions peuvent faire l'objet, le cas échéant, d'une neutralisation avant la sortie du canon à ions. Dans ce cas, le bombardement sera toujours considéré comme ionique. Le bombardement ionique provoque un réarrangement atomique et une densification dans la couche en cours de dépôt, ce qui permet de la tasser pendant qu'elle est en train d'être formée.

Lors de la mise en oeuvre du procédé selon l'invention, la surface à traiter est préférentiellement bombardée par des ions, d'une densité de courant généralement comprise entre 20 et 1000 $\mu A/cm^2$, préférentiellement entre 30 et 500 $\mu A/cm^2$, mieux entre 30 et 200 $\mu A/cm^2$ sur la surface activée et généralement sous une pression résiduelle dans l'enceinte à vide pouvant varier de $6.10^{-5}$ mbar à $2.10^{-4}$ mbar, préférentiellement de $8.10^{-5}$ mbar à $2.10^{-4}$ mbar. On utilise de préférence un faisceau d'ions argon et/ou oxygène. Lorsqu'un mélange d'argon et d'oxygène est employé, le ratio molaire Ar / $O_2$ est de préférence $\leq 1$, mieux $\leq 0{,}75$ et encore mieux $\leq 0{,}5$. Ce ratio peut être contrôlé en ajustant les débits de gaz dans le canon à ions. Le débit d'argon varie de préférence de 0 à 30 sccm. Le débit d'oxygène $O_2$ varie de préférence de 5 à 30 sccm, et est d'autant plus grand que le débit des composés précurseurs de la couche A est élevé.

Les ions du faisceau d'ions, préférentiellement issus d'un canon à ions, utilisés au cours du dépôt de la couche A ont de préférence une énergie allant de 5eV à 1000 eV, mieux de 5 à 500 eV, préférentiellement 75 à 150 eV, préférentiellement de 80 à 140 eV, mieux de 90 à 110 eV. Les espèces activées formées sont typiquement des radicaux ou des ions.

En cas de bombardement ionique lors du dépôt, il est possible d'effectuer un traitement par plasma concomitamment ou non au dépôt sous faisceau d'ions de la couche A. De préférence, le dépôt de la couche est effectué sans l'assistance d'un plasma au niveau des substrats.

Le dépôt de ladite couche A s'effectue en présence d'une source d'oxygène lorsque le composé B précurseur ne contient pas (ou pas suffisamment) d'atomes d'oxygène et que l'on souhaite que la couche A contienne une certaine proportion d'oxygène. De même, le dépôt de ladite couche A s'effectue en présence d'une source d'azote lorsque le composé B précurseur ne contient pas (ou pas suffisamment) d'atomes d'azote et que l'on souhaite que la couche A contienne une certaine proportion d'azote.

D'une manière générale, on préfère introduire du gaz oxygène avec le cas échéant une faible teneur en gaz azote, de préférence en l'absence de gaz azote.

Outre la couche A, d'autres couches du revêtement interférentiel peuvent être déposées sous bombardement ionique tel que décrit ci-dessus, c'est-à-dire en utilisant un bombardement au moyen d'un faisceau d'ions de la couche en cours de formation, émis de préférence par un canon à ions.

La méthode préférée pour la vaporisation des matériaux précurseurs de la couche A, conduite sous vide, est le dépôt physique en phase vapeur, en particulier l'évaporation sous vide, généralement combinée à un chauffage des composés à évaporer. Elle peut être mise en jeu en utilisant des systèmes d'évaporation aussi divers qu'une source thermique à effet Joule (l'effet Joule est la manifestation thermique de la résistance électrique) ou un canon à électrons pour les précurseurs liquides ou solides, tout autre dispositif connu de l'homme du métier pouvant également être utilisé.

Le composé B précurseur de la couche A est de préférence introduit dans l'enceinte à vide dans laquelle est réalisée la préparation des articles selon l'invention sous forme gazeuse, en contrôlant son débit. Ceci signifie qu'il n'est de préférence pas vaporisé à l'intérieur de l'enceinte à vide (contrairement à l'oxyde de titane précurseur). L'alimentation en composé B précurseur de la couche A se situe à une distance de la sortie du canon à ions variant de préférence de 30 à 50 cm.

De préférence, l'oxyde de titane est préchauffé de manière à se trouver dans un état fondu puis évaporé. Il est de préférence déposé par évaporation sous vide en utilisant un canon à électrons pour provoquer sa vaporisation.

Le composé B précurseur et l'oxyde de titane précurseur sont déposés de façon concomitante (par exemple par co-évaporation) ou partiellement concomitante, c'est-à-dire avec chevauchement des étapes de dépôt de l'un et de l'autre précurseur. Dans ce dernier cas, le dépôt de l'un des deux précurseurs commence avant le dépôt de l'autre, le dépôt du second précurseur débutant avant la fin du dépôt du premier précurseur.

Le composé B organosilicié, précurseur de la couche A, est de nature organique, et contient dans sa structure au moins un atome de silicium et au moins un atome de carbone. Il comporte de préférence au moins une liaison Si-C, et comporte de préférence au moins un atome d'hydrogène. Selon un mode de réalisation, le composé B comprend au moins un atome d'azote et/ou au moins un atome d'oxygène, de préférence au moins un atome d'oxygène.

La concentration de chaque élément chimique dans la couche A (Ti, Si, O, C, H, N...) peut être déterminée en utilisant la technique RBS (Rutherford Backscattering Spectrometry), et ERDA (Elastic Recoil Detection Analysis).

Le pourcentage atomique en atomes de titane dans la couche A varie de préférence de 10 à 30 %. Le pourcentage atomique en atomes de carbone dans la couche A varie de préférence de 10 à 20 %. Le pourcentage atomique en atomes d'hydrogène dans la couche A varie de préférence de 10 à 30 %. Le pourcentage atomique en atomes de silicium dans la couche A varie de préférence de 10 à 20 %. Le pourcentage atomique en atomes d'oxygène dans la couche A varie de préférence de 20 à 40 %.

Des exemples non limitatifs de composés organiques B, cycliques ou non cycliques, sont les composés suivants : l'octaméthylcyclotétrasiloxane (OMCTS), le décaméthylcyclopentasiloxane, le dodécaméthylcyclohexasiloxane, l'hexaméthyl cyclotrisiloxane, l'hexaméthyldisiloxane (HMDSO), l'octaméthyltrisiloxane, le décaméthyltétrasiloxane, le dodécaméthylpentasiloxane, le tétraéthoxysilane, le vinyltriméthylsilane, l'hexaméthyldisilazane, l'hexaméthyldisilane, l'hexaméthylcyclotrisilazane, le vinylméthyldiéthoxysilane, le divinyltétraméthyldisiloxane, le tétraméthyldisiloxane., le polydiméthylsiloxane (PDMS), le poly-phénylméthylsiloxane (PPMS) ou un tétraalkylsilane tel que le tétraméthylsilane.

De préférence, le composé B comporte au moins un atome de silicium porteur d'au moins un groupe alkyle, de préférence en C1-C4, mieux au moins un atome de silicium porteur d'un ou de deux groupes alkyle identiques ou différents, de préférence en C1-C4, par exemple le groupe méthyle.

Les composés B précurseurs de la couche A préférés comportent un groupe Si-O-Si, mieux, un groupe divalent de formule (3) :

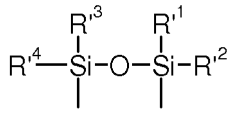

où $R'^1$ à $R'^4$ désignent indépendamment des groupes alkyle ou vinyle linéaires ou ramifiés, de préférence en C1-C4, par exemple le groupe méthyle, des groupes aryle monocyclique ou polycyclique, hydroxyle ou des groupes hydrolysables. Des exemples non limitatifs de groupes hydrolysables sont les groupes H, halogène (chloro, bromo, iodo...), alcoxy, aryloxy, acyloxy, - $NR^1R^2$ où $R^1$ et $R^2$ désignent indépendamment un atome d'hydrogène, un groupe alkyle ou un groupe aryle, et $-N(R^3)-Si$ où $R^3$ désigne un atome d'hydrogène, un groupe alkyle linéaire ou ramifié, de préférence en C1-C4 ou un groupe aryle, monocyclique ou polycyclique, de préférence monocyclique. Les groupes comportant un chaînon Si-O-Si ne sont pas considérés comme étant des "groupes hydrolysables" au sens de l'invention. Le groupe hydrolysable préféré est l'atome d'hydrogène.

Selon un autre mode de réalisation, le composé B précurseur de la couche A répond à la formule :

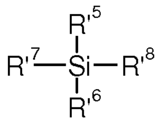

dans laquelle R'5, R'6, R'7, R'8 désignent indépendamment des groupes hydroxyle ou des groupes hydrolysables tels que des groupes OR, dans lesquels R est un groupe alkyle.

Selon un premier mode de réalisation, le composé B comporte au moins un atome de silicium porteur de deux groupes alkyle identiques ou différents, de préférence en C1-C4. Selon ce premier mode de réalisation, le composé B est de préférence un composé de formule (3) dans laquelle $R'^1$ à $R'^4$ désignent indépendamment des groupes alkyle, de préférence en C1-C4, par exemple le groupe méthyle.

De préférence, le ou les atomes de silicium du composé B ne comportent aucun groupe hydrolysable ou groupe hydroxyle dans ce mode de réalisation.

Le ou les atomes de silicium du composé B précurseur de la couche A sont de préférence uniquement liés à des groupes alkyle et/ou des groupes comportant un chaînon -O-Si ou -NH-Si de façon à former un groupe Si-O-Si ou Si-NH-Si. Les composés précurseurs de la couche A préférés sont l'OMCTS et le HMDSO.

Il s'agit préférentiellement d'un polysiloxane cyclique de formule (4) :

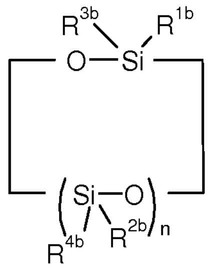

où n désigne un entier allant de 2 à 20, de préférence de 3 à 8, $R^{1b}$ à $R^{4b}$ représentent indépendamment des groupes alkyle linéaires ou ramifiés, de préférence en C1-C4 (par exemple le groupe méthyle), vinyle, aryle ou un groupe hydrolysable. Les membres préférés appartenant à ce groupe sont les octa-alkylcyclotétrasiloxanes (n = 3), de préférence l'octaméthylcyclotétrasiloxane (OMCTS). Dans certains cas, la couche A est issue d'un mélange d'un certain nombre de composés de formule (4) où n peut varier dans les limites indiquées ci-dessus.

Selon un second mode de réalisation, le composé B contient dans sa structure au moins un groupe Si-X', où X' est un groupe hydroxy ou un groupe hydrolysable, qui peut être choisi, sans limitation, parmi les groupes H, halogène, alcoxy, aryloxy, acyloxy, $-NR^1R^2$ où $R^1$ et $R^2$ désignent indépendamment un atome d'hydrogène, un groupe alkyle ou un groupe aryle, et - $N(R^3)$-Si où $R^3$ désigne un atome d'hydrogène, un groupe alkyle ou un groupe aryle.

Selon ce second mode de réalisation de l'invention, le composé B contient de préférence dans sa structure au moins un groupe Si-H, c'est-à-dire constitue un hydrure de silicium. De préférence, l'atome de silicium du groupe Si-X' n'est pas lié à plus de deux groupes non hydrolysables tels que des groupes alkyle ou aryle.

Parmi les groupes X', les groupes acyloxy ont préférentiellement pour formule $-OC(O)R^4$ où $R^4$ est un groupe aryle préférentiellement en C6-C12, éventuellement substitué par un ou plusieurs groupes fonctionnels, ou alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle, les groupes aryloxy et alcoxy ont pour formule $-O-R^5$ où $R^5$ est un groupe aryle préférentiellement en C6-C12, éventuellement substitué par un ou plusieurs groupes fonctionnels, ou alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle, les halogènes sont préférentiellement F, Cl, Br ou I, les groupes X' de formule $-NR^1R^2$ peuvent désigner un groupe amino $NH_2$, alkylamino, arylamino, dialkylamino, diarylamino, $R^1$ et $R^2$ désignant indépendamment un atome d'hydrogène, un groupe aryle préférentiellement en C6-C12, éventuellement substitué par un ou plusieurs groupes fonctionnels, ou un groupe alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle, les groupes X' de formule $-N(R^3)$-Si sont rattachés à l'atome de silicium par l'intermédiaire de leur atome d'azote et leur atome de silicium comporte naturellement trois autres substituants, où $R^3$ désigne un atome d'hydrogène, un groupe aryle préférentiellement en C6-C12, éventuellement substitué par un ou plusieurs groupes fonctionnels, ou un groupe alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle.

Le groupe acyloxy préféré est le groupe acétoxy. Le groupe aryloxy préféré est le groupe phénoxy. Le groupe halogène préféré est le groupe Cl. Les groupes alcoxy préférés sont les groupes méthoxy et éthoxy.

Dans le second mode de réalisation, le composé B comporte de préférence au moins un atome de silicium porteur d'au moins un groupe alkyle, de préférence en C1-C4 linéaire ou ramifié, mieux au moins un atome de silicium porteur d'un ou de deux groupes alkyle identiques ou différents, de préférence en C1-C4, et d'un groupe X' (de préférence un atome d'hydrogène) directement lié à l'atome de silicium, X' ayant la signification indiquée précédemment. Le groupe alkyle préféré est le groupe méthyle. Le groupe vinyle peut également être utilisé à la place d'un groupe alkyle. De préférence, l'atome de silicium du groupe Si-X' est directement lié à au moins un atome de carbone.

De préférence, chaque atome de silicium du composé B n'est pas lié directement à plus de deux groupes X', mieux n'est pas lié directement à plus d'un groupe X' (de préférence un atome d'hydrogène), mieux, chaque atome de silicium du composé B est lié directement à un seul groupe X' (de préférence un atome d'hydrogène). De préférence, le composé B comporte un ratio atomique Si/O égal à 1. De préférence, le composé B comporte un ratio atomique C/Si $<2$, préférentiellement $\leq 1,8$, mieux $\leq 1,6$ et mieux encore $\leq 1,5$, $\leq 1, 3$ et de façon optimale égal à 1. De préférence encore, le composé B comporte un ratio atomique C/O égal à 1. Selon un mode de réalisation, le composé B ne comporte pas de groupe Si-N, mieux ne comporte pas d'atome d'azote.

Le ou les atomes de silicium du composé B précurseur de la couche A sont de préférence uniquement liés à des groupes alkyle, hydrogène et/ou des groupes comportant un chaînon -O-Si ou -NH-Si de façon à former un groupe Si-O-Si ou Si-NH-Si. Dans un mode de réalisation, le composé B comporte au moins un groupe Si-O-Si-X' ou au moins

un groupe Si-NH-Si-X', X' ayant la signification indiquée précédemment et représentant de préférence un atome d'hydrogène.

Selon ce second mode de réalisation, le composé B est de préférence un composé de formule (3) dans laquelle l'un au moins de $R'^1$ à $R'^4$ désigne un groupe X' (de préférence un atome d'hydrogène), X' ayant la signification indiquée précédemment.

Selon ce second mode de réalisation, le composé B est préférentiellement un polysiloxane cyclique de formule (5) :

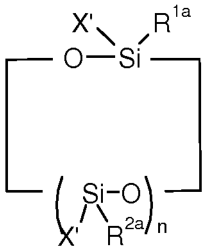

où X' a la signification indiquée précédemment et représente de préférence un atome d'hydrogène, n désigne un entier allant de 2 à 20, de préférence de 3 à 8, $R^{1a}$ et $R^{2a}$ représentent indépendamment un groupe alkyle de préférence en C1-C4 (par exemple le groupe méthyle), vinyle, aryle ou un groupe hydrolysable. Des exemples non limitatifs de groupes X' hydrolysables sont les groupes chloro, bromo, alcoxy, acyloxy, aryloxy, H. Les membres les plus courants appartenant à ce groupe sont les tétra-, penta- et hexa-alkylcyclotétrasiloxanes, de préférence les tétra-, penta- et hexa-méthylcyclotétrasiloxanes, le 2,4,6,8-tétraméthylcyclotétrasiloxane (TMCTS) étant le composé préféré. Dans certains cas, la couche A est issue d'un mélange d'un certain nombre de composés ayant la formule ci-dessus où n peut varier dans les limites indiquées ci-dessus.

Selon un autre mode de réalisation, le composé B est un alkylhydrosiloxane linéaire, mieux un méthylhydrosiloxane linéaire tel que par exemple le 1,1,1,3,5,7,7,7-octaméthyl tétrasiloxane, le 1,1,1,3,5,5,5-heptaméthyltrisiloxane, le 1,1,3,3,5,5-hexaméthyl trisiloxane.

Des exemples non-limitatifs de composés organiques B précurseurs de la couche A, cycliques ou non cycliques, conformes au second mode de réalisation, sont les composés suivants : le 2,4,6,8-tétraméthylcyclotétrasiloxane (TMCTS de formule (1)), le 2,4,6,8-tétraéthylcyclotétrasiloxane, le 2,4,6,8-tétraphénylcyclotétrasiloxane, le 2,4,6,8-tétraoctylcyclotétrasiloxane, le 2,2,4,6,6,8-hexaméthylcyclotétrasiloxane, le 2,4,6-triméthylcyclotrisiloxane, le cyclotétrasiloxane, le 1,3,5,7,9-pentaméthyl cyclopentasiloxane, le 2,4,6,8,10-hexaméthylcyclohexasiloxane, le 1,1,1,3,5,7,7,7-octaméthyl tétrasiloxane, le 1,1,3,3,5,5-hexaméthyltrisiloxane, le tétraméthyldisiloxane, le tétraéthoxysilane, le vinylméthyldiéthoxysilane, un hexaméthylcyclotrisilazane tel que le 3,4,5,6-hexaméthylcyclotrisilazane ou le 2,2,4,4,6,6-hexaméthylcyclotrisilazane, le 1,1,1,3,5,5,5-heptaméthyl trisiloxane, le tris(trimethylsiloxy)silane (de formule (2)), le 1,1,3,3-tétraméthyldisilazane, le 1,2,3,4,5,6,7,8-octaméthylcyclotétrasilazane, le nonaméthyl trisilazane, le tris(diméthylsilyl)amine, l'hexaméthyldisilazane.

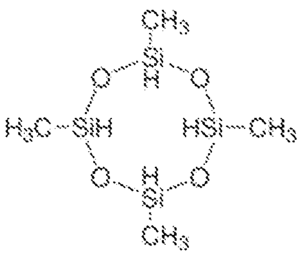

(1)

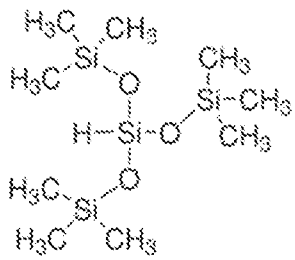

(2)

L'oxyde de titane précurseur de la couche A peut être le dioxyde titane $TiO_2$ ou un oxyde de titane sous-stoechiométrique de formule TiOx, avec x < 2, x variant de préférence de 0,2 à 1,2. L'oxyde de titane de l'invention ne comporte de préférence pas d'azote.

Selon le mode de réalisation préféré, l'oxyde de titane est un oxyde de titane sous-stoechiométrique. Il peut s'agir notamment du TiO, $Ti_2O_3$, ou du $Ti_3O_5$ Comme annoncé précédemment, la couche A peut être formée à partir d'un ou plusieurs oxydes de titane, par exemple un mélange de TiO et de $Ti_2O_3$, notamment par co-évaporation de ces composés. De préférence, la proportion massique de TiO dans le mélange de TiO et de $Ti_2O_3$ est d'au moins 50 %, de préférence d'au moins 60 %, et mieux encore d'au moins 70 %.

L'utilisation d'oxyde de titane est avantageuse en raison de l'indice de réfraction élevé de cet oxyde métallique. L'indice de réfraction du $TiO_2$ sous forme rutile est effectivement de l'ordre de 2,65 à 550 nm. Ainsi, la couche A peut conserver un indice de réfraction élevé (≥ 1,8) même si l'oxyde de titane est mélangé avec un un composé B organosilicié d'indice de réfraction plus faible.

L'utilisation d'au moins un composé B pour former la couche A, qui comporte notamment des liaisons Si-C et éventuellement Si-O, permet de bénéficier de propriétés thermomécaniques améliorées par rapport aux matériaux de haut indice de réfraction traditionnels tels que $TiO_2$ ou $ZrO_2$, notamment la tenue à la température et la résistance à la rayure des substrats revêtus par les couches A selon l'invention permettent d'atteindre des niveaux jusque-là inaccessibles par les technologies traditionnelles telles que le dépôt de couches purement inorganiques sous assistance ionique.

Selon un mode de réalisation de l'invention, la couche A comprend plus de 80 % en masse de composés issus du composé B et de l'oxyde de titane selon l'invention, par rapport à la masse totale de la couche A, de préférence plus de 90 %. Selon un mode de réalisation, la couche A est exclusivement formée par dépôt sous vide et sous bombardement ionique d'au moins un oxyde de titane et d'au moins un composé B organosilicié, à l'exclusion de tout autre précurseur. De préférence, la couche A ne comprend pas de composé fluoré.

De préférence, la couche A ne contient pas une phase distincte d'oxydes métalliques. La couche A étant formée par dépôt sous vide, elle ne comprend pas d'hydrolysat de composé organosilicié et se distingue donc des revêtements sol-gel obtenus par voie liquide.

La durée du processus de dépôt, les débits et pressions sont ajustés de façon à obtenir l'épaisseur de revêtement désirée.

La couche A possède de préférence une épaisseur allant de 20 à 150 nm, mieux de 25 à 120 nm et encore mieux de 60 à 100 nm.

Les conditions de dépôt, notamment les proportions relatives du composé B et de l'oxyde de titane, sont choisies de façon à ce que l'on obtienne, après le dépôt des deux précurseurs, une couche A présentant :

- un indice de réfraction à 550 nm supérieur ou égal à 1,8,
- un coefficient d'extinction k à 550 nm inférieur ou égal à 0,02, ce qui signifie que la couche A est faiblement absorbante,
- un ratio H/E supérieur ou égal à 0,046, mieux supérieur ou égal à 0,05, où H et E , désignent respectivement la dureté du matériau et le module d'élasticité du matériau exprimé H et E étant de préférence exprimées en MPa ou GPa,
- de préférence un angle de contact statique avec l'eau supérieur ou égal à 70°, mieux supérieur ou égal à 80°, et encore mieux supérieurou égal à 90°, variant de préférence de 70 à 95°,
- de préférence une contrainte variant de -350 MPa à +150 MPa.

La nature des composés employés, leurs quantités respectives (qui peuvent être modulées en ajustant les débits évaporés), et la durée du dépôt sont des exemples de paramètres que l'homme du métier saura faire varier pour parvenir au revêtement ayant les propriétés souhaitées, en particulier à l'aide des exemples de la présente demande.

Le coefficient d'extinction (aussi appelé coefficient d'atténuation) d'une substance particulière, noté k, mesure la perte d'énergie d'un rayonnement électromagnétique traversant ce milieu. C'est la partie imaginaire de l'indice de réfraction complexe. De préférence, les couches A selon l'invention ont un coefficient d'extinction k inférieur ou égal à 0,02 pour toute longueur d'onde allant de 400 à 800 nm.

Le module d'élasticité E du matériau formant la couche A et sa dureté H sont mesurés par essai de pénétration instrumenté (indentation), selon une méthode détaillée en partie expérimentale. En cas de besoin, on se réfèrera à la norme NF EN ISO 14577. La dureté H caractérise la capacité du matériau à résister à une indentation permanente ou à une déformation lorsqu'il est mis en contact avec un indenteur sous une charge de compression. Le module d'élasticité E (ou module d'Young, ou module de conservation, ou module d'élasticité en traction) permet d'évaluer la capacité du matériau à se déformer sous l'effet d'une force appliquée. Le ratio H/E exprime la résistance à la fracture (résistance à la propagation de la craquelure).

La couche et les articles selon l'invention présentent une bonne résistance à la fracture.

Le module d'élasticité E du matériau formant la couche A varie de préférence de 60 MPa à 120 MPa.

D'autres propriétés à prendre en compte lors de la conception d'un article selon l'invention, comportant par exemple un revêtement interférentiel, sont les contraintes mécaniques. La contrainte de la couche A varie de préférence de -350 MPa à +150 MPa, mieux de -200 à -50 MPa, ce qui signifie qu'elle est plus faible que celle d'une couche purement inorganique de $TiO_2$ déposée par évaporation sous assistance ionique. Elle est mesurée à la température de 20°C et sous 50 % d'humidité relative de la façon décrite dans la demande WO 2013/098531. Ce sont les conditions de dépôt de l'invention qui permettent de parvenir à cette contrainte.

La contrainte du revêtement interférentiel selon l'invention varie en général de 0 à - 400 MPa, de préférence de -50 à -300 MPa, mieux de -80 à -250 MPa, et encore mieux de -100 à -200 MPa.

Les couches A de l'invention possèdent des allongements à la rupture supérieurs à ceux des couches inorganiques, et peuvent subir des déformations sans se fissurer. De ce fait, l'article selon l'invention possède une résistance accrue à la courbure.

La température critique d'un article revêtu selon l'invention est de préférence supérieure ou égale à 70°C, mieux supérieure ou égale à 80°C et encore mieux supérieure ou égale à 90°C. Dans la présente demande, la température critique d'un article ou d'un revêtement est définie comme étant celle à partir de laquelle on observe l'apparition de craquelures dans l'empilement présent à la surface du substrat, ce qui traduit une dégradation du revêtement. Cette température critique élevée est due à la présence de la couche A à la surface de l'article, comme démontré dans la partie expérimentale. Par ailleurs, les couches A obtenues possèdent une aptitude plus faible à se charger en eau que des couches inorganiques évaporées. Les couches A obtenues selon l'invention, intégrées ou non dans un revêtement interférentiel ont une excellente stabilité dans le temps de leurs propriétés optiques.

Grâce à ses propriétés thermomécaniques améliorées, la couche A, faisant partie ou non d'un revêtement interférentiel, peut notamment être appliquée sur une seule face d'une lentille semi-finie, généralement sa face avant, l'autre face de cette lentille devant encore être usinée et traitée. L'empilement présent sur la face avant de la lentille ne sera pas dégradé par l'accroissement de température générée par les traitements que subira la face arrière lors du durcissement des revêtements qui auront été déposés sur cette face arrière ou toute autre action susceptible d'augmenter la température de la lentille.

Selon un mode de réalisation préféré, le revêtement interférentiel de l'invention est un revêtement antireflet comprenant, dans l'ordre de dépôt sur la surface du substrat éventuellement revêtu, une couche de $ZrO_2$, généralement de 10 à 40 nm d'épaisseur et préférentiellement de 15 à 35 nm, une couche de $SiO_2$, généralement de 10 à 40 nm d'épaisseur et préférentiellement de 15 à 35 nm, une couche A, généralement de 40 à 150 nm d'épaisseur, préférentiellement de 50 à 120 nm, une couche d'ITO ou de $SnO_2$, généralement de 1 à 15 nm d'épaisseur et préférentiellement de 2 à 10 nm, et une couche de $SiO_2$, généralement de 50 à 150 nm d'épaisseur et préférentiellement de 60 à 100 nm.

De préférence, le facteur moyen de réflexion dans le domaine visible (400-700 nm) d'un article revêtu d'un revêtement interférentiel selon l'invention, noté $R_m$, est inférieur à 2,5 % par face, mieux inférieur à 2 % par face et encore mieux inférieur à 1 % par face de l'article. Dans un mode de réalisation optimal, l'article comprend un substrat dont les deux surfaces principales sont revêtues d'un revêtement interférentiel selon l'invention et présente une valeur de $R_m$ totale (cumul de réflexion due aux deux faces) inférieure à 1%. Les moyens pour parvenir à de telles valeurs de $R_m$ sont connus de l'homme du métier.

Le facteur de réflexion lumineux $R_v$ d'un revêtement interférentiel selon l'invention est inférieur à 2,5 % par face, de préférence inférieur à 2 % par face, mieux inférieur à 1 % par face de l'article, mieux $\leq$ 0,75 %, mieux encore $\leq$ 0,5 %.

Dans la présente demande, le "facteur moyen de réflexion" $R_m$ (moyenne de la réflexion spectrale sur l'ensemble du spectre visible entre 400 et 700 nm) et le facteur de réflexion lumineux $R_v$ sont tels que définis dans la norme ISO 13666:1998, et mesurés conformément à la norme ISO 8980-4.

Dans certaines applications, il est préférable que la surface principale du substrat soit revêtue d'un ou plusieurs revêtements fonctionnels préalablement au dépôt de la couche A ou du revêtement multicouche comprenant la couche A. Ces revêtements fonctionnels classiquement utilisés en optique peuvent être, sans limitation, une couche de primaire améliorant la résistance au choc et/ou l'adhésion des couches ultérieures dans le produit final, un revêtement anti-abrasion et/ou anti-rayures, un revêtement polarisé, un revêtement photochromique, électrochromique ou un revêtement coloré, en particulier une couche de primaire revêtue d'une couche anti-abrasion et/ou anti-rayures. Ces deux derniers revêtements sont décrits plus en détail dans les demandes WO 2008/015364 et WO 2010/109154.

L'article selon l'invention peut également comporter des revêtements formés sur la couche A ou le revêtement multicouche la comprenant, capables de modifier ses propriétés de surface, tels qu'un revêtement hydrophobe et/ou oléophobe (top coat antisalissure) ou un revêtement antibuée. Ces revêtements sont de préférence déposés sur la couche A ou la couche externe d'un revêtement interférentiel. Leur épaisseur est en général inférieure ou égale à 10 nm, de préférence de 1 à 10 nm, mieux de 1 à 5 nm. Ils sont respectivement décrits dans les demandes WO 2009/047426 et WO 2011/080472.

Les revêtements hydrophobes et/ou oléophobes sont définis comme des revêtements dont l'angle de contact statique avec de l'eau désionisée est supérieur ou égal à 75°, de préférence supérieur ou égal à 90°, et mieux supérieur ou égal à 100°. Dans la présente demande, les angles de contact statiques peuvent être déterminés selon la méthode de la goutte de liquide, selon laquelle une goutte de liquide ayant un diamètre inférieur à 2 mm est déposée doucement sur une surface solide non absorbante et l'angle à l'interface entre le liquide et la surface solide est mesuré.

Le revêtement hydrophobe et/ou oléophobe est de préférence un revêtement de type fluorosilane ou fluorosilazane. Il peut être obtenu par dépôt d'un fluorosilane ou fluorosilazane précurseur, comprenant de préférence au moins deux groupes hydrolysables par molécule. Les fluorosilanes précurseurs contiennent préférentiellement des groupements fluoropolyéthers et mieux des groupements perfluoropolyéthers.

De préférence, le revêtement externe hydrophobe et/ou oléophobe a une énergie de surface égale ou inférieure

à 14 mJ/m$^2$, de préférence égale ou inférieure à 13 mJ/m$^2$, mieux égale ou inférieure à 12 mJ/m$^2$. L'énergie de surface est calculée selon la méthode Owens-Wendt décrite dans la référence: « Estimation of the surface force energy of polymers » Owens D. K., Wendt R. G. (1969), J. Appl. Polym. Sci., 13, 1741-1747. Les liquides utilisés sont l'eau et le diiodométhane.

Des composés utilisables pour obtenir de tels revêtements sont décrits dans les brevets JP2005187936 et US6183872. Des compositions commerciales permettant de préparer des revêtements hydrophobes et/ou oléophobes sont la composition KY130® de la société Shin-Etsu Chemical ou la composition OPTOOL DSX®, commercialisée par la société Daikin Industries.

Typiquement, un article selon l'invention comprend un substrat successivement revêtu d'une couche de primaire d'adhésion et/ou antichoc, d'un revêtement anti-abrasion et/ou anti-rayure, d'un revêtement interférentiel optionnellement antistatique comprenant une couche A selon l'invention, et d'un revêtement hydrophobe et/ou oléophobe.

L'invention est illustrée, de façon non limitative, par les exemples suivants. Sauf indication contraire, les indices de réfraction sont donnés pour une longueur d'onde de 550 nm et T = 20-25°C.

EXEMPLES

1. Procédures générales

Les articles employés dans les exemples comprennent un substrat de lentille ORMA® ESSILOR de 65 mm de diamètre, de puissance -2,00 dioptries et d'épaisseur 1,2 mm, revêtu sur sa face concave du revêtement de primaire antichoc et du revêtement anti-abrasion et anti-rayures (hard coat) divulgués dans la partie expérimentale de la demande WO 2010/109154, et une couche A selon l'invention.

Le bâti de dépôt sous vide est une machine Leybold Boxer pro équipée d'un canon à électrons pour l'évaporation des matériaux précurseurs, d'un évaporateur thermique, d'un canon à ions KRI EH 1000 F (de la société Kaufman & Robinson Inc.) pour la phase préliminaire de préparation de la surface du substrat par des ions argon (IPC), ainsi que pour le dépôt de la couche A sous bombardement ionique (IAD), et d'un système d'introduction de liquide, utilisé lorsque le composé précurseur de la couche A est un liquide dans les conditions normales de température et de pression (cas de l'OMCTS). Ce système comprend un réservoir contenant le composé précurseur liquide de la couche A, des résistances pour chauffer le réservoir et les tubes reliant le réservoir de précurseur liquide à la machine de dépôt sous vide, un débitmètre pour la vapeur de la société MKS (MKS1150C), porté à une température de 30-120°C lors de son utilisation, selon le débit d'OMCTS vaporisé, qui varie de préférence de 0,01 à 0,8 g/min (la température est de 100°C pour un débit de 0,3 g/min d'OMCTS).

La vapeur d'OMCTS sort d'un tuyau en cuivre à l'intérieur de la machine, à une distance d'environ 30 cm du canon à ions. Des débits d'oxygène et éventuellement d'argon sont introduits à l'intérieur du canon à ions. Préférentiellement, il n'est pas introduit d'argon ni aucun autre gaz rare à l'intérieur du canon à ions.

Les couches A selon l'invention sont formées par évaporation sous vide assistée par faisceau d'ions oxygène et éventuellement argon pendant le dépôt (source d'évaporation : canon à électrons) d'octaméthylcyclotétrasiloxane, fourni par la société Sigma-Aldrich et d'un oxyde de titane sous-stoechiométrique ("$Ti_3O_5$ stabilisé") fourni par la société Merck.

Sauf indication contraire, les épaisseurs mentionnées sont des épaisseurs physiques. Plusieurs échantillons de chaque verre ont été préparés.

2. Modes opératoires

Le procédé de préparation des articles d'optique selon l'invention comprend l'introduction du substrat revêtu du revêtement de primaire et du revêtement anti-abrasion définis ci-dessus dans l'enceinte de dépôt sous vide, le préchauffage du réservoir, des tuyaux et du débitmètre à vapeur à la température choisie (~ 15 min), une étape de pompage primaire, puis de pompage secondaire pendant 400 s permettant l'obtention d'un vide secondaire (~2. $10^{-5}$ mbar, pression lue sur une jauge Bayard-Alpert), une étape d'activation de la surface du substrat par un faisceau d'ions argon (IPC : 1 minute, 100 V, 1 A, le canon à ions restant en fonctionnement à la fin de cette étape), puis le dépôt par évaporation de la couche A, réalisé de la façon suivante.

Le canon à ions ayant été démarré avec de l'argon, de l'oxygène est ajouté dans le canon à ions avec un débit programmé, le courant d'anode souhaité est programmé (3 A) et le débit d'argon est éventuellement arrêté, selon les conditions de dépôt souhaitées. D'une manière générale, le procédé selon l'invention est effectué avec de l'oxygène ($O_2$) introduit dans le canon à ions, en l'absence de gaz rare.

L'oxyde de titane sous-stoechiométrique est préchauffé de manière à se trouver dans un état fondu puis évaporé à l'aide d'un canon à électrons, l'obturateur du canon à ions et celui du canon à électrons étant ouverts simultanément. Dans le même temps, le composé OMCTS est introduit dans l'enceinte sous forme gazeuse, à un débit ou une pression

partielle contrôlé(e).

L'épaisseur des couches déposées a été contrôlée en temps réel au moyen d'une microbalance à quartz, en modifiant si besoin la vitesse de dépôt en ajustant le courant du canon à électrons. Une fois l'épaisseur souhaitée obtenue, les deux obturateurs sont fermés, les canons à ions et électrons arrêtés, et les débits de gaz (oxygène, éventuellement argon et vapeurs d'OMCTS) sont arrêtés.

Enfin, une étape de ventilation est réalisée.

L'exemple comparatif 1 diffère de l'empilement selon l'invention en ce que la couche A est remplacée par une couche obtenue à partir du seul précurseur $Ti_3O_5$.

L'exemple comparatif 2 diffère de l'empilement selon l'invention en ce que la couche A est remplacée par une couche obtenue à partir du seul précurseur ZrO.

Les exemples comparatifs 3-5 diffèrent des empilements selon l'invention en ce que la couche A est remplacée par une couche obtenue à partir des précurseurs ZrO et OMCTS.

## 3. Caractérisations

La température critique de l'article est mesurée 24 heures après sa préparation, de la façon indiquée dans la demande WO 2008/001011.

Les mesures d'indice de réfraction n et de coefficient d'extinction k (défini dans la demande WO 2005/059603) ont été réalisées à la longueur d'onde de 550 nm par ellipsométrie Plus précisément, l'indice de réfraction et le coefficient d'extinction sont obtenus par des mesures ellipsométriques en utilisant un ellipsomètre (RC2, J. A. Woollam) équipé d'un double compensateur rotatif. L'indice de réfraction et le coefficient d'extinction sont déduits de la relation de dispersion qui modélise la réponse optique fournie par les angles ellipsométriques $\Psi$ et $\Delta$. Pour des matériaux diélectriques tels que $TiO_2$, l'équation de Tauc-Lorentz, connue de l'homme du métier) modélise bien les propriétés optiques des couches déposées. Toutes les mesures ont été effectuées à des angles d'incidence de 45°, 55°, 65° et 75° dans une gamme de longueurs d'onde de 190-1700 nm.

La dureté H et le module d'élasticité E du matériau constituant la couche A ont été évalués par mesure de nano-indentation. Celle-ci consiste à faire pénétrer une pointe, encore appelée indenteur, de géométrie et propriétés mécaniques connues, à savoir une pointe diamant Berkovich sous une force variant de 100 $\mu$N à 10000 $\mu$N dans une couche de matériau A de 500 nm d'épaisseur déposée sur un support de silice « silicon wafer » et enregistrer la force appliquée en fonction de la profondeur de pénétration h de la pointe. Ces deux paramètres sont mesurés de façon continue lors d'une phase de charge et d'une phase de décharge pour en déduire les propriétés mécaniques de la couche A.

Le modèle utilisé pour le calcul de la dureté et du module élastique est celui développé par Oliver et Pharr.

L'aire de contact (Ac) pour un indenteur Berkovich est Ac=24,56 x $h_c^2$

La dureté du matériau est obtenue en calculant le rapport de la force maximum appliquée sur la surface mesurée (aire de contact Ac entre l'indenteur et l'échantillon),

$$H = \frac{F_{max}}{A_c} \qquad h_c = h_{max} - \varepsilon \cdot \frac{F_{max}}{S}$$

et le module d'élasticité E est déduit de la courbe d'indentation (courbe force-pénétration).

$$S = \frac{\partial F}{\partial h} = \frac{2}{\sqrt{\pi}} E_r \sqrt{A_c}$$

$$\frac{1}{E_r} = \frac{1 - \upsilon^2_i}{E_i} + \frac{1 - \upsilon^2}{E}$$

Er est le module réduit, Ei est le module de l'indenteur, $\upsilon$ est le coefficient de Poisson.

L'appareil de mesure utilisé est un appareil TriboIndenter de la marque Hysitron.

4. Résultats

Le tableau 1 ci-dessous présente les performances optiques et mécaniques de différents articles selon l'invention ou comparatifs ainsi que les conditions de dépôt des différentes couches.

**Tableau 1**

| Exemple | Précurseur inorganique | Vitesse de dépôt massique [μg/cm²/s] | Pression partielle OMCTS [mTorr] | Débit d'oxygène / d'argon [sccm] | Courant d'anode [A] | Indice de réfraction à 550 nm | k à 550 nm | T critique [°C] | H/E |
|---|---|---|---|---|---|---|---|---|---|
| 1 | $Ti_3O_5$ | 0,2 | 0,05 | 20/0 | 3 | 2,09 | 0,004 | 90 | 0,051 |
| 2 | $Ti_3O_5$ | 0,2 | 0,1 | 30/0 | 3 | 1,9 | 0,02 | 70 | 0,047 |
| 3 | $Ti_3O_5$ | 0,2 | 0,02 | 20/0 | 3 | 2,13 | $< 10^{-4}$ | | 0,053 |
| 4 | $Ti_3O_5$ | 0,1 | 0,05 | 20/0 | 4 | 2,03 | $< 10^{-4}$ | | 0,062 |
| C1 | $Ti_3O_5$ | 0,2 | 0 | 30/0 | 3 | 2,25 | $< 10^{-4}$ | 50 | 0,039 |
| C2 | ZrO | 20** | 0 | 16/0 | 0 | 2,02 | 0,004 | 50 | 0,038 |
| C3 | ZrO | 20** | 0,1* | 10/10 | 3 | 1,73 | 0,002 | | 0,057 |
| C4 | ZrO | 20** | 0,2* | 10/10 | 3 | 1,60 | $4.10^{-4}$ | | 0,054 |
| C5 | ZrO | 20** | 0,5* | 10/10 | 3 | 1,49 | 0,003 | | 0,066 |

* : Débit d'OMCTS en g/min. ** : Vitesse de dépôt en A/s (valeur programmée).

Les articles selon l'invention présentent une température critique et un ratio H/E nettement améliorés par rapport à une couche exclusivement composée d'oxyde de titane (exemple comparatif C1), tout en conservant un coefficient d'extinction à 550 nm relativement bas et un indice de réfraction élevé.

L'indice de réfraction des couches hybrides à base d'oxydes métalliques de haut indice de réfraction diminue naturellement lorsque l'on augmente le débit d'OMCTS.

La co-évaporation d'OMCTS et de ZrO pré-fondu conduit à des couches hybrides à base de zircone ne donnant pas satisfaction (exemples comparatifs C3-C5) du fait d'un indice de réfraction trop faible, même pour un débit d'OMCTS très bas (0,1 g/min, exemple comparatif C3).

Il a en outre été vérifié que les empilements selon l'invention résistaient à une exposition aux UV en conservant des propriétés optiques et mécaniques stables.

## Revendications

1. Article transparent comprenant un substrat ayant au moins une surface principale revêtue d'une couche A d'un matériau obtenu par dépôt sous vide, assisté par une source d'ions, à partir d'au moins un oxyde de titane et d'au moins un composé B organosilicié, déposés de façon concomitante ou partiellement concomitante, **caractérisé en ce que** ledit matériau présente :

   - un indice de réfraction à 550 nm supérieur ou égal à 1,8,
   - un coefficient d'extinction k à 550 nm inférieur ou égal à 0,02,
   - un ratio H/E supérieur ou égal à 0,046, où H et E désignent respectivement la dureté du matériau et le module d'élasticité du matériau.

2. Article selon la revendication 1, **caractérisé en ce que** le dépôt assisté par une source d'ions est un bombardement ionique.

3. Article selon la revendication 1 ou 2, **caractérisé en ce que** le composé B comporte au moins une liaison Si-C.

4. Article selon l'une quelconque des revendications précédentes, **caractérisé en ce que** le composé B comporte au moins un groupe divalent de formule :

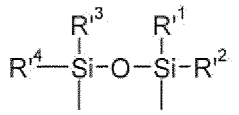

   où R'1 à R'4 désignent indépendamment des groupes alkyle, vinyle, aryle, hydroxyle ou des groupes hydrolysables, ou **en ce que** le composé B répond à la formule :

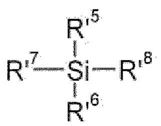

   dans laquelle R'5, R'6, R'7, R'8 désignent indépendamment des groupes hydroxyle ou des groupes hydrolysables tels que des groupes OR, dans lesquels R est un groupe alkyle.

5. Article selon l'une quelconque des revendications précédentes, **caractérisé en ce que** le composé B est choisi parmi l'octaméthylcyclotétrasiloxane, le 2,4,6,8-tétraméthylcyclotétrasiloxane, le décaméthyltétrasiloxane, le décaméthylcyclopentasiloxane, le dodécaméthylpentasiloxane, l'hexaméthyldisiloxane.

6. Article selon l'une quelconque des revendications précédentes, **caractérisé en ce que** le ou les atomes de silicium du composé B ne comportent aucun groupe hydrolysable ou groupe hydroxyle.

7. Article selon l'une quelconque des revendications précédentes, **caractérisé en ce que** l'oxyde de titane est un oxyde de titane sous-stoechiométrique.

8. Article selon l'une quelconque des revendications précédentes, **caractérisé en ce que** la couche A a une épaisseur allant de 20 à 150 nm.

9. Article selon l'une quelconque des revendications précédentes, **caractérisé en ce que** la couche A constitue une couche d'un revêtement interférentiel multicouche.

10. Article selon la revendication 9, **caractérisé en ce que** le revêtement interférentiel est un revêtement antireflet.

11. Article selon l'une quelconque des revendications précédentes, **caractérisé en ce qu'**il est une lentille optique, de préférence une lentille ophtalmique.

12. Article selon l'une quelconque des revendications précédentes, **caractérisé en ce que** la contrainte de la couche A varie de -350 à +150 MPa.

13. Article selon l'une quelconque des revendications précédentes, **caractérisé en ce que** la couche A possède un angle de contact statique avec l'eau supérieur ou égal à 70°.

14. Article selon l'une quelconque des revendications précédentes, **caractérisé en ce qu'**il possède une température critique supérieure ou égale à 70°C.

15. Procédé de fabrication d'un article selon l'une quelconque des revendications précédentes, comprenant au moins les étapes suivantes :

   - fournir un article comprenant un substrat ayant au moins une surface principale,
   - déposer sur ladite surface principale du substrat une couche A d'un matériau ayant un indice de réfraction supérieur ou égal à 1,8, un coefficient d'extinction k à 550 nm inférieur ou égal à 0,02, un ratio H/E supérieur ou égal à 0,046, où H et E désignent respectivement la dureté du matériau et le module d'élasticité du matériau,
   - récupérer un article comprenant un substrat ayant une surface principale revêtue d'une couche A,

   ladite couche A ayant été obtenue par dépôt sous vide et sous bombardement ionique d'au moins un oxyde de titane et d'au moins un composé B organosilicié.

**Patentansprüche**

1. Durchsichtiger Gegenstand, der ein Substrat umfasst, welches mindestens eine Hauptoberfläche aufweist, die mit einer Schicht A aus einem Material überzogen ist, welches ausgehend von mindestens einem Titanoxid und mindestens einem einer Organosiliciumverbindung B, mit Unterstützung durch eine Ionenquelle, durch Vakuumabscheidung erhalten wurde, wobei diese gleichzeitig oder teilweise gleichzeitig abgeschieden wurden, **dadurch gekennzeichnet, dass** das Material Folgendes aufweist:

   - einen Brechungsindex von mindestens 1,8 bei 550 nm,
   - einen Auslöschungskoeffizienten k von höchstens 0,02 bei 550 nm,
   - ein H/E-Verhältnis von mindestens 0,046, wobei H und E die Härte des Materials beziehungsweise den Elastizitätsmodul des Materials bezeichnen.

2. Gegenstand nach Anspruch 1, **dadurch gekennzeichnet, dass** es sich bei der Abscheidung mit Unterstützung durch eine Ionenquelle um einen Ionenbeschuss handelt.

3. Gegenstand nach Anspruch 1 oder 2, **dadurch gekennzeichnet, dass** die Verbindung B mindestens eine Si-C-Verbindung aufweist.

4. Gegenstand nach einem der vorhergehenden Ansprüche, **dadurch gekennzeichnet, dass** die Verbindung B mindestens eine zweibindige Gruppe der folgenden Formel aufweist:

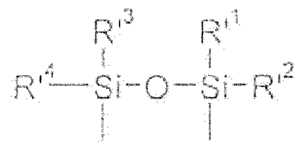

wobei $R'^1$ bis $R'^4$ unabhängig voneinander für Alkyl- , Vinyl-, Aryl-, Hydroxylgruppen oder für hydrolysierbare Gruppen stehen, oder dadurch, dass die Verbindung B der folgenden Formel entspricht:

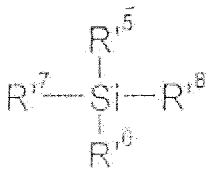

in welcher R'5, R'6, R'7, R'8 unabhängig voneinander für Hydroxylgruppen oder für hydrolysierbare Gruppen wie etwa OR-Gruppen stehen, in denen R eine Alkylgruppe ist.

**5.** Gegenstand nach einem beliebigen der vorhergehenden Ansprüche, **dadurch gekennzeichnet, dass** die Verbindung B aus Octamethylcyclotetrasiloxan, 2, 4, 6, 8-Tetramethylcyclotetrasiloxan, Decamethyltetrasiloxan, Decamethylcyclopentasiloxan, Dodecamethylpentasiloxan, Hexamethyldisiloxan ausgewählt ist.

**6.** Gegenstand nach einem beliebigen der vorhergehenden Ansprüche, **dadurch gekennzeichnet, dass** das oder die Siliciumatome der Verbindung B keinerlei hydrolysierbare Gruppe oder Hydroxylgruppe aufweisen.

**7.** Gegenstand nach einem beliebigen der vorhergehenden Ansprüche, **dadurch gekennzeichnet, dass** es sich bei dem Titanoxid um ein unterstöchiometrisches Titanoxid handelt.

**8.** Gegenstand nach einem beliebigen der vorhergehenden Ansprüche, **dadurch gekennzeichnet, dass** die Schicht A eine Dicke von 20 bis 150 nm hat.

**9.** Gegenstand nach einem beliebigen der vorhergehenden Ansprüche, **dadurch gekennzeichnet, dass** die Schicht A eine Schicht einer mehrschichtigen Interferenzbeschichtung darstellt.

**10.** Gegenstand nach Anspruch 9, **dadurch gekennzeichnet, dass** es sich bei der Interferenzbeschichtung um eine Antireflexbeschichtung handelt.

**11.** Gegenstand nach einem beliebigen der vorhergehenden Ansprüche, **dadurch gekennzeichnet, dass** es sich um eine optische Linse, vorzugsweise eine augenmedizinische Linse, handelt.

**12.** Gegenstand nach einem beliebigen der vorhergehenden Ansprüche, **dadurch gekennzeichnet, dass** die Belastbarkeit der Schicht A einen Bereich von -350 bis +150 MPa abdeckt.

**13.** Gegenstand nach einem beliebigen der vorhergehenden Ansprüche, **dadurch gekennzeichnet, dass** die Schicht A einen statischen Kontaktwinkel mit Wasser besitzt, der mindestens 70° beträgt.

**14.** Artikel nach einem beliebigen der vorhergehenden Ansprüche, **dadurch gekennzeichnet, dass** er eine kritische Temperatur von mindestens 70 °C besitzt.

**15.** Verfahren zur Herstellung eines Gegenstands nach einem beliebigen der vorhergehenden Ansprüche, wobei es mindestens die folgenden Schritte umfasst:

- Bereitstellen eines Gegenstands, der ein Substrat umfasst, welches mindestens eine Hauptoberfläche aufweist,
- Abscheiden, auf der Hauptoberfläche des Substrats, einer Schicht A aus einem Material, das einen Brechungsindex von mindestens 1,8, einen Auslösungskoeffizienten k von höchstens 0,02 bei 550 nm, ein H/E-Verhältnis von mindestens 0,046 aufweist, wobei H und E die Härte des Materials beziehungsweise den Elastizitätsmodul

des Materials bezeichnen,
- Entnehmen eines Gegenstands, der ein Substrat umfasst, welches eine Hauptoberfläche aufweist, die mit einer Schicht A überzogen ist,

wobei die Schicht A erhalten wurde, indem mindestens ein Titanoxid und mindestens eine Organosiliciumverbindung B unter Vakuum und unter Ionenbeschuss abgeschieden wurden.

## Claims

1. A transparent article comprising a substrate having at least one main surface coated with a layer A of a material obtained by vacuum deposition assisted by a source of ions, from at least one titanium oxide and at least one organosilicon compound B, deposited concomitantly or partially concomitantly, **characterized in that** said material exhibits:

    - a refractive index at 550 nm of greater than or equal to 1.8,
    - an extinction coefficient k at 550 nm of less than or equal to 0.02,
    - an H/E ratio of greater than or equal to 0.046, where H and E respectively denote the hardness of the material and the modulus of elasticity of the material.

2. The article as claimed in claim 1, **characterized in that** the deposition assisted by a source of ions is an ion bombardment.

3. The article as claimed in claim 1 or 2, **characterized in that** the compound B comprises at least one Si-C bond.

4. The article as claimed in any one of the preceding claims, **characterized in that** the compound B comprises at least one divalent group of formula:

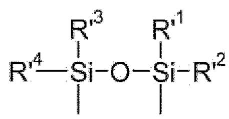

where $R'^1$ to $R'^4$ independently denote alkyl, vinyl, aryl or hydroxyl groups or hydrolysable groups, or **in that** the compound B corresponds to the formula:

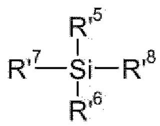

in which $R'^5$, $R'^6$, $R'^7$ and $R'^8$ independently denote hydroxyl groups or hydrolysable groups, such as OR groups, in which R is an alkyl group.

5. The article as claimed in any one of the preceding claims, **characterized in that** the compound B is chosen from octamethylcyclotetrasiloxane, 2,4,6,8-tetramethylcyclotetrasiloxane, decamethyltetrasiloxane, decamethylcyclopentasiloxane, dodecamethylpentasiloxane or hexamethyldisiloxane.

6. The article as claimed in any one of the preceding claims, **characterized in that** the silicon atom or atoms of the compound B do not comprise any hydrolysable group or hydroxyl group.

7. The article as claimed in any one of the preceding claims, **characterized in that** the titanium oxide is a substoichiometric titanium oxide.

8. The article as claimed in any one of the preceding claims, **characterized in that** the layer A has a thickness ranging from 20 to 150 nm.

9. The article as claimed in any one of the preceding claims, **characterized in that** the layer A constitutes a layer of

a multilayer interference coating.

**10.** The article as claimed in claim 9, **characterized in that** the interference coating is an antireflective coating.

**11.** The article as claimed in any one of the preceding claims, **characterized in that** it is an optical lens, preferably an ophthalmic lens.

**12.** The article as claimed in any one of the preceding claims, **characterized in that** the stress of the layer A varies from -350 to +150 MPa.

**13.** The article as claimed in any one of the preceding claims, **characterized in that** the layer A possesses a static contact angle with water of greater than or equal to 70°.

**14.** The article as claimed in any one of the preceding claims, **characterized in that** it possesses a critical temperature of greater than or equal to 70°C.

**15.** A process for the manufacture of an article as claimed in any one of the preceding claims, comprising at least the following stages:

- providing an article comprising a substrate having at least one main surface;
- depositing, on said main surface of the substrate, a layer A of a material having a refractive index of greater than or equal to 1.8, an extinction coefficient k at 550 nm of less than or equal to 0.02 and an H/E ratio of greater than or equal to 0.046, where H and E respectively denote the hardness of the material and the modulus of elasticity of the material,
- recovering an article comprising a substrate having a main surface coated with a layer A,

said layer A having been obtained by vacuum deposition under ion bombardment of at least one titanium oxide and of at least one organosilicon compound B.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- WO 2013098531 A
- EP 1324078 A
- US 6919134 B
- JP 2007078780 A
- JP 5323103 A
- WO 2008062142 A
- WO 2010109154 A
- US 5508368 A
- WO 2008015364 A
- WO 2009047426 A
- WO 2011080472 A
- JP 2005187936 B
- US 6183872 B
- WO 2008001011 A
- WO 2005059603 A


### Littérature non-brevet citée dans la description


- Thin Film Processes" and "Thin Film Processes II. Academic Press, 1978
- **OWENS D. K. ; WENDT R. G.** Estimation of the surface force energy of polymers. *J. Appl. Polym. Sci.,* 1969, vol. 13, 1741-1747